Europäisches Patentamt

European Patent Office

Office européen des brevets

(11) Publication number: **0 209 754
A2**

## (12) EUROPEAN PATENT APPLICATION

(21) Application number: 86108711.2

(22) Date of filing: 26.06.86

(51) Int. Cl.⁴: **H 03 C 3/09**

(30) Priority: 15.07.85 US 755257

(43) Date of publication of application:
28.01.87 Bulletin 87/5

(84) Designated Contracting States:
DE FR GB IT NL SE

(71) Applicant: MOTOROLA, INC.
1303 East Algonquin Road
Schaumburg, Illinois 60196(US)

(72) Inventor: Heck, Joseph Paul
7308 Bristlecone Court
Fort Worth Texas 76137(US)

(74) Representative: Ibbotson, Harold
Motorola Ltd Patent and Licensing Operations - Europe
Jays Close Viables Industrial Estate
Basingstoke Hampshire RG22 4PD(GB)

(54) Two-part synthesizer modulation system using a reference phase modulator.

(57) An improved frequency modulator arrangement for use in a phase-locked loop frequency synthesizer is disclosed which provides high deviation, low distortion, FM signals from a wide range of modulating signals such as digital data or low frequency tone modulation. This arrangement advantageously injects the modulation signal into two ports, one at the VCO and the other at an added phase modulator. The added phase modulator is inserted ahead of either input to the phase detector of the phase-locked loop. By properly balancing the level and polarity of the modulation signal into each of these two ports, a cancellation effect occurs which nulls the modulation signal at the output of the phase detector. Thus, in the first three embodiments, the added phase modulator is inserted in the reference source signal path to the phase detector, while in an alternate fourth embodiment, the phase modulator is inserted into the feedback path and includes a phase inverter stage to correct for the inherent modulation polarity reversal.

./...

MODULATION INPUT

22

24

26

18

10

12

REFERENCE SOURCE

14

FREQUENCY MODULATOR

16

PHASE DETECTOR

VOLTAGE CONTROLLED OSCILLATOR

OUTPUT FREQUENCY

20

*Fig. 1*

## TWO-PORT SYNTHESIZER MODULATION SYSTEM
### USING A REFERENCE PHASE MODULATOR

BACKGROUND OF THE INVENTION

The present invention relates generally to modulators and more particularly to an improved method and arrangement for modulating phase-locked loop frequency synthesizers. This arrangement can accommodate signals such as digital data or low frequency tone modulation and can produce high deviation, low distortion, FM signals while exhibiting a flat, wide, modulation bandwidth that is independent of the phase-locked loop bandwidth.

Today's communications systems require efficient use of the crowded radio spectrum, especially in congested metropolitan areas. To achieve efficient use of this limited congested spectrum, modern communications systems use elaborate data and tone-coded signalling schemes which place constraints on the overall transmitter design. Such transmitters may be expected to maintain their carrier frequency with high stability and yet offer fast lock time and wide deviation capability, all of which limit the ways in which the transmitter may be modulated.

In any event, certain techniques have been developed which provide the desired carrier frequency stability and yet allow wide deviation capabilities. Such techniques, generally utilizing a high stability unmodulated reference oscillator in conjunction with a phase-locked loop frequency synthesizer, allow for quick change of channels while maintaining the required system frequency stability. These phase-locked loop arrangements generally include a frequency divider in the loop feedback path which allows for ease of channel selection and which also provides a way in which to effect wide output deviation.

One known improvement utilizes dual port modulation of a frequency synthesizer loop applying modulation to both the voltage controlled oscillator and through a summing network to the phase detector output to achieve wide deviation capability for low frequency tones while maintaining a high degree of frequency stability. While such an arrangement is suitable for some system designs, it nevertheless suffers from two serious drawbacks.

The first disadvantage is that it does not balance the two modulation ports over a wide bandwidth if there are variations in the phase detector gain. In such an arrangement, any temperature variations in phase detector gain will change the effect of modulation sensitivity. Where the modulation sensitivity is high, any variation can be significant.

A second disadvantage of such an arrangement is that the reference modulation input must be maintained in phase synchronism with the VCO (voltage controlled oscillator) modulation components in a suitable delay network, such as a sample and hold circuit. Without such a delay network, the frequency synthesizer suffers degradation to data modulation, especially with relatively fast data rates. There will also be additional spurious output sidebands generated in such an arrangement due to the lack of a suitable delay network. This correspondingly greater spurious output requires additional attenuation in the loop filter to prevent degrading the synthesizer's spurious output performance still further. Each of these disadvantages leads to serious compromises in system performance which are undesirable.

Accordingly, there exists a need for an improved frequency modulated phase-locked loop frequency synthesizer arrangement which is able to accommodate signals such as data or low frequency tone modulation and which can produce high deviation, low distortion, FM signals while exhibiting a flat, wide, modulation bandwidth that is indepenent of the phase-locked loop bandwidth.

## SUMMARY OF THE INVENTION

It is an object of the present invention to provide an improved, frequency modulated phase-locked loop frequency synthesizer arrangement having high stability and wide deviation capability which overcomes the foregoing deficiencies.

It is a further object of the present invention to provide an improved frequency modulated phase-locked loop frequency synthesizer arrangement of the foregoing type having high stability and a modulation frequency response which is independent of the loop bandwidth.

In practicing the invention, a frequency modulator arrangement is provided which includes a high stability unmodulated reference oscillator within a phase-locked loop frequency synthesizer. A selectable-integer loop divider is incorporated which not only selects the desired output frequency, but also provides a way to achieve the desired wide deviation capability. The modulation information is injected at two separate ports within the phase-locked loop frequency synthesizer. The first port is at the input of the voltage controlled oscillator, while the second port consists of a serrasoid-type phase modulator interposed between the output of the fixed divider and the reference signal input of the phase detector. The modulation of the reference signal is accomplished by frequency modulating the critical, or rising, edge of the output of the reference divider before it is applied to the phase detector. The modulation information inputted to the phase modulator is first integrated in order to produce frequency modulation of the reference signal. With the modulated output signal fed back through the loop divider and nulled with the modulated reference signal, the preferred embodiment of the present invention overcomes the disadvantages of the known prior art. Another embodiment of the present invention utilizes the frequency modulator in the feedback path between the loop divider and the phase detector in conjunction with a phase inverter to achieve cancellation of the modulation before applying the signal to the phase detector. The result of using either of these two port modulation systems is an essentially flat modulation frequency response having a widened usable bandwidth, as well as a widened deviation capability given by the factor N of the loop divider, each being set independently of the loop bandwidth.

These and other objects of the present invention will become apparent to those skilled in the art upon consideration of the accompanying specification, claims, and drawings.

.

## BRIEF DESCRIPTION OF THE DRAWINGS

Referring to the drawings, wherein like reference numerals indicate like elements in the several figures and in which:

Figure 1 is a block diagram of a frequency modulator arrangement illustrating the simplest form of the present invention.

Figure 2 is a more detailed block diagram of a modulator arrangement embodying the present invention

0209754

wherein an included fixed divider and loop divider, as well as the frequency modulator consisting of a phase modulator and integrator, are shown.

Figure 3 is a functional representation of a type of serrasoid modulator useful with the present invention.

Figure 4, a through d, depicts signal diagrams showing the function of the serrasoid modulator as represented in Figure 3.

Figure 5 is a schematic diagram of the preferred serrasoid modulator embodied in the present invention as represented in functional form in Figure 3.

Figure 6 is another embodiment of the frequency modulated phase-locked loop frequency synthesizer showing an offset method for generating wide deviation high frequency RF signals at a low carrier frequency.

Figure 7 is another embodiment of the frequency-modulated phase-locked loop frequency synthesizer utilizing the frequency modulator in the feedback path between the loop divider and the phase detector in conjunction with a modulation phase inverter.

## DETAILED DESCRIPTION

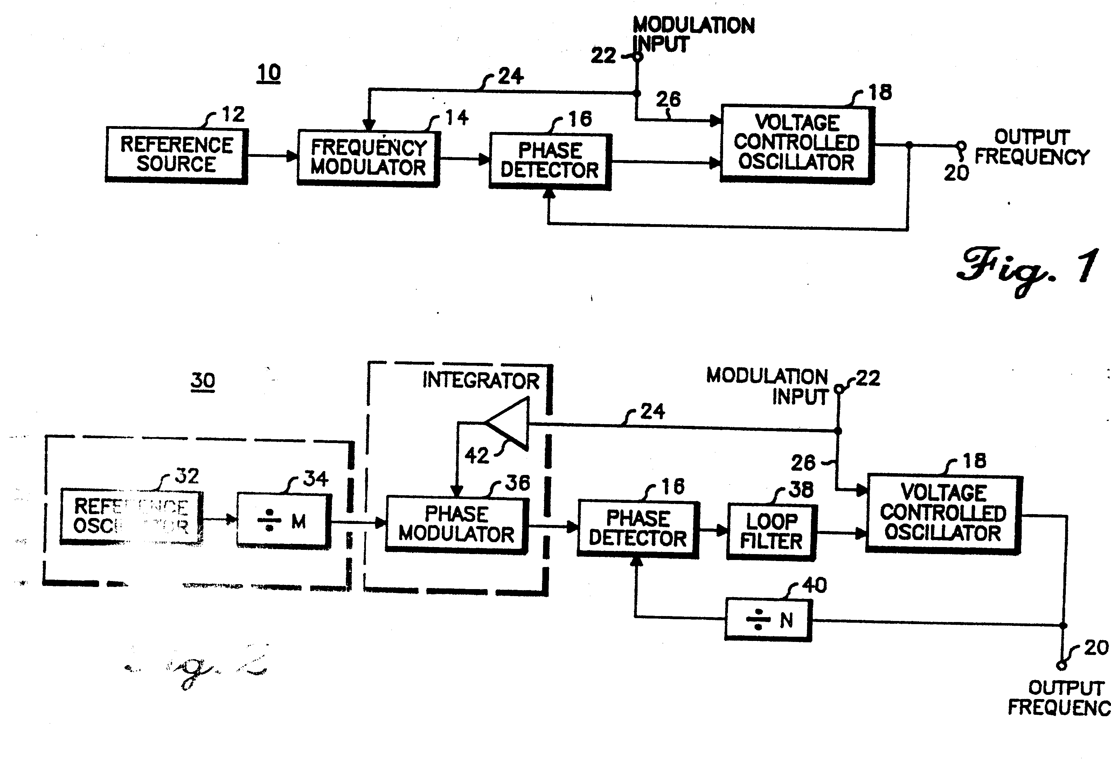

Referring now to the drawings, a basic phase-locked loop (or PLL) frequency synthesizer arrangement 10 is shown in Figure 1 which, as indicated, includes a two-port modulation capability. This PLL synthesizer arrangement consists of a reference source 12, a frequency modulator 14, a phase detector 16, a voltage controlled oscillator (or VCO) 18 having an output 20, a portion of which is fed back to phase detector 16. The modulating signal enters at 22 and is fed to each of the two ports, 24 and 26, so as to modulate the frequency of output 20. Thus, by using this two-port modulation arrangement on a PLL frequency synthesizer, cancellation of the two modulating signals at the output of phase detector 16 results.

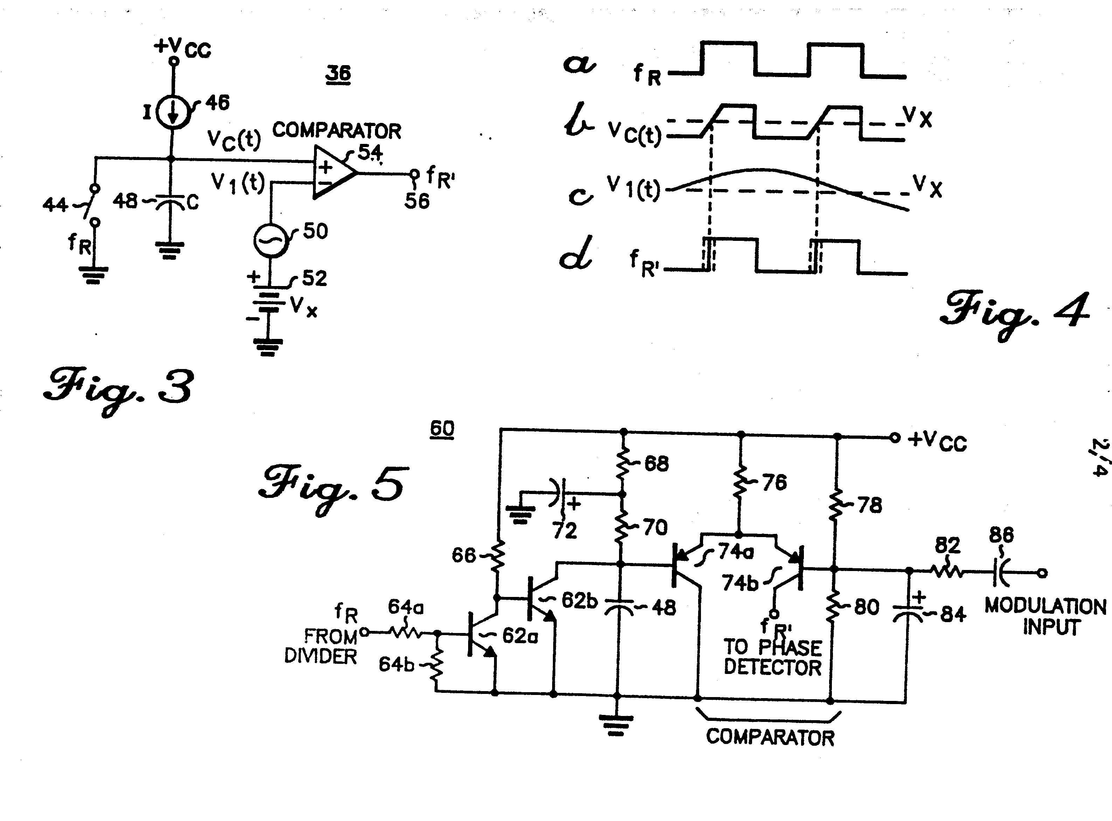

A preferred embodiment of the modulated PLL frequency synthesizer arrangement of the present invention depicted at 30 that is more likely to be utilized in a multi-channel transmitter or transceiver is shown in Figure 2. Like numerals are employed for corresponding components wherever applicable. In this embodiment, the PLL consists of a reference oscillator 32, such as a high stability oscillator of any suitable design of known art, a fixed-integer divider 34, a phase modulator 36, a phase detector 16, a loop filter 38, a VCO 18 having an output 20, a portion of which is fed back through variable-integer divider 40 to phase detector 16. In this embodiment, an integrator 42 is used in conjunction with phase modulator 36 to effect frequency modulation of the reference signal going into the phase detector 16. This arrangement, like the one in Figure 1, depends on cancellation of the modulating signals at the output of the phase detector 16 to achieve the wide output deviation at low distortion. The arrangement 30 of Figure 2 allows the modulation signal bandwidth to be set independently of the requirements for the loop bandwidth which is controlled by means of loop filter 38. More particularly, the use of a loop divider 40 provides the capability of magnifying the effective deviation maintained by cancellation of the modulating signals at the output of phase detector 16.

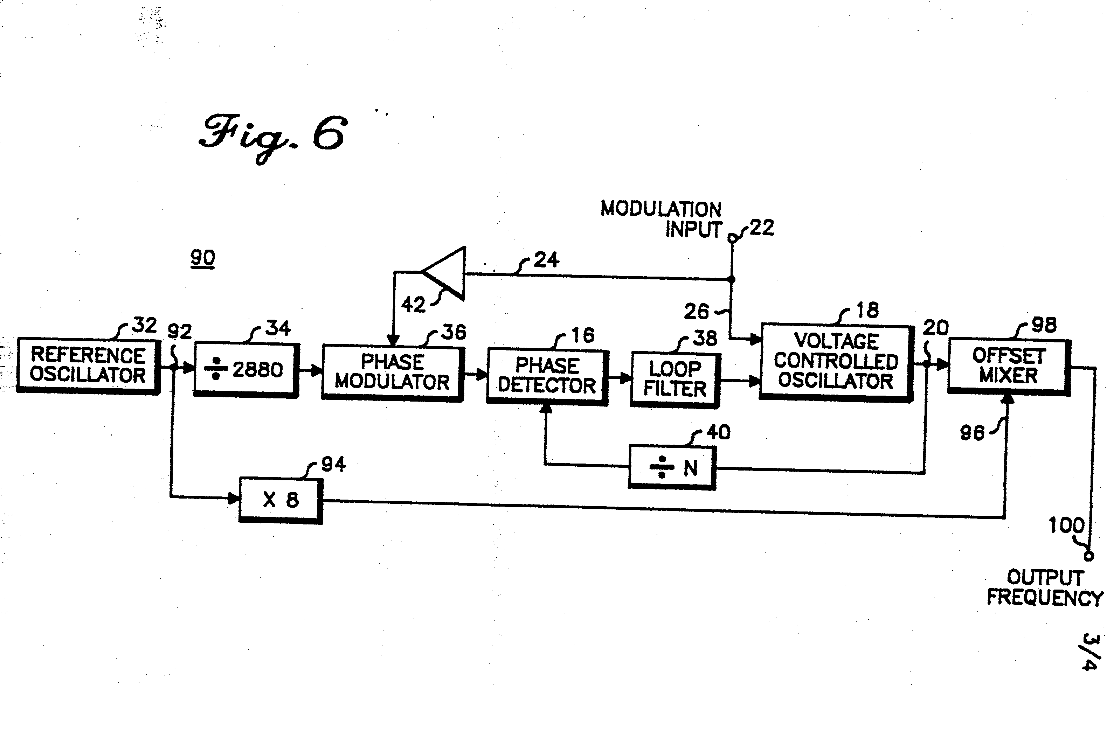

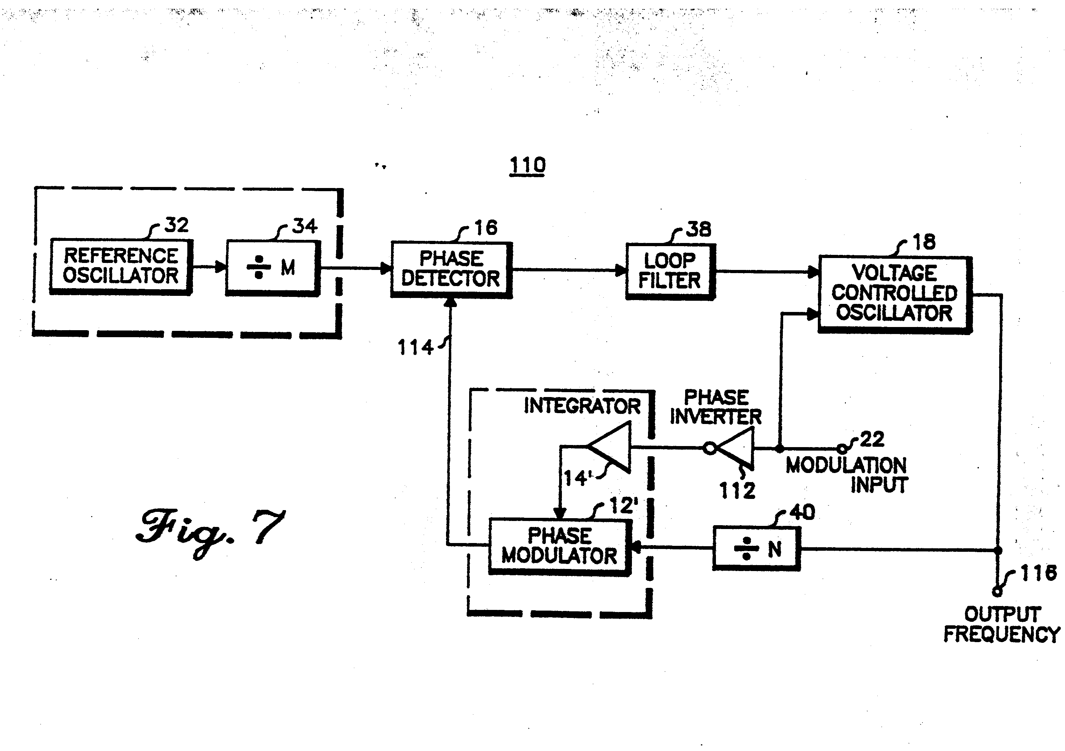

A basic diagram of the phase modulator depicted at 36 having an inherent phase inversion is shown in Figure 3 and is of the serrasoid type. A switch 44, acted upon by reference frequency $f_r$, creates a pulse stream at the periodic rate of $f_r$ having a voltage ramp on the critical, or rising, edge due to current source 46 and capacitor 48. This effect is shown by Figures 4b, 4c. This signal is compared with the value of the modulation signal 50 (plus a D.C. bias voltage 52) in connection with comparator 54.

The resultant modulated reference signal $f_r$ appears at output 56 of comparator 54. The signals are shown in Figures 4a-4d. Any serrasoid modulator which modulates the trip voltage of comparator 54 or modulates the slope of the ramp such that the rising edge shifts so as to affect the phase detector may be used.

A preferred embodiment of the type of serrasoid phase modulator explained above and again having an inherent phase inversion is shown at 60 in Figure 5. The switch being toggled by reference frequency $f_r$ consists of transistors 62a-b with associated bias circuitry 64a-b, 66. The current source consists of resistors 68, 70 filtered by capacitor 72, feeding capacitor 48. The resultant modulated reference signal $f_r$ is sent to the comparator which consists of transistors 74a-b and associated bias resistor 76, and compared with the modulation signal inputted through bias network 78, 80 by integrator network 82, 84 and coupling capacitor 86. Thus, by modulating the trip voltage of the comparator, the serrasoid phase modulator generates a modulated reference signal.

Still another arrangement of a modulated PLL frequency synthesizer apparatus embodying the present invention is depicted at 90 in Figure 6. This arrangement is especially useful for lower frequency ranges requiring proportionally large deviation with low distortion. As will be noted, it is similar to the PLL synthesizer depicted in Figure 2, but takes the reference oscillator signal at 92, passes it through a multiplier 94 to the injection port 96 of an offset mixer 98 in order to offset or down-mix the modulated signal 20 to a lower frequency 100 while maintaining the same amount of deviation with low distortion.

Finally, an alternate embodiment of a modulated PLL frequency synthesizer apparatus embodying the present invention is depicted at 110 in Figure 7. As will be noted, it is similar to the PLL synthesizer arrangement depicted in Figure 2, but instead utilizes the frequency modulator consisting of phase modulator 12' and integrator 14' with a phase inverter 112 to achieve cancellation of the modulation components of the loop feedback signal 114 before inputting this feedback signal to phase detector 16. The modulated output frequency appears at output 116.

In summary, each of the above-mentioned arrangements 10, 30, 90, and 110 are able to accomplish the modulation of the PLL without losing gain balance between the two ports 24, 26 caused by variations in phase detector gain and without the need for a suitable delay network for maintaining proper phase synchronization of the modulated reference and modulated VCO signal components. Each exhibits an essentially flat, wide modulation bandwidth that is independent of the PLL bandwidth. Thus they are able to overcome the limitations of the known prior art.

Although the several two-port synthesizer modulation arrangements of the present invention fully disclose many of the attendant advantages, it is understood that various changes and modifications not depicted herein are apparent to those skilled in the art. Therefore, even though the form of the above-described invention is merely a preferred or exemplary embodiment given with practical alternates, further variations may be made in the form, construction, and arrangement of the parts without departing from the scope of the above invention.

I CLAIM:

1.     Frequency modulation apparatus for modulating the output of a phase-locked loop frequency synthesizer providing an essentially flat modulating frequency response independent of the loop bandwidth, said apparatus comprising:

reference signal source means (12) for producing a high stability unmodulated reference signal at a desired frequency;

voltage controlled oscillator means (18) for generating an output signal whose frequency is proportional to a D.C. input voltage;

phase-locked loop means for feeding back a portion of said output signal (20) to included phase detector means (16), the latter detecting the phase difference between said reference signal and said output feedback signal and producing an output correction signal for maintaining said voltage controlled oscillator means (18) at a desired frequency; and

two-port modulation means for introducing modulation at an input (26) of said voltage controlled oscillator means (18) and at an input (24) of said phase detector means (16) with a balanced amplitude and polarity whereby the resultant modulation effected by said two-port modulation means is nulled at the output of said phase detector means (16).

CM-00107N
0209754

2.      The apparatus of claim 1 wherein said means for modulating the frequency of said high stability unmodulated reference signal includes a frequency modulator (14).

3.      The apparatus of claim 1 and 2 wherein said frequency modulator (14) includes a phase modulator (36) and an integrator (42).

4.          A circuit for frequency modulating the output of a phase-locked loop frequency synthesizer providing an essentially flat modulating frequency response independent of the loop bandwidth, said circuit comprising in combination:

a phase-locked loop frequency synthesizer having a high stability, unmodulated reference signal source (12), a phase detector (16), a voltage controlled oscillator (18), and a feedback path between said voltage controlled oscillator (18) and said phase detector (16);

a frequency modulator (14) interposed between said high stability, unmodulated reference signal source (12) and said phase detector (16); and

a direct frequency modulation port (26) included at said voltage controlled oscillator (18),

said frequency modulator (14) and said direct frequency modulation port (26) being adapted for simultaneous feed in synchronism with a balanced amplitude and polarity so as to effect cancellation of the modulation at the output of said phase detector (16) and thereby provide an essentially flat modulating frequency response independent of the bandwidth of said phase-locked loop frequency synthesizer.

5. The circuit of claim 4 wherein said frequency modulator (14) includes a phase modulator (36) and an integrator (42).

6. The circuit of claim 5 wherein said phase modulator (36) includes a serrasoid phase modulator (60).

7. The circuit of claim 6, wherein said serrasoid phase modulator (60) comprises at least a voltage ramp generator (48,68,70,72), a voltage comparator (74a,74b) having an input coupled to said voltage ramp generator, and a transistor switch (62a,62b) for modulating a given input signal by modulating the trip voltage of said voltage comparator and thereby affecting the critical edge of the output waveform of said voltage comparator.

8. The circuit of claim 6, wherein said serrasoid phase modulator (60) comprises at least a voltage ramp generator, a voltage comparator having an input coupled to said voltage ramp generator, and a transistor switch for modulating a given input signal by modulating the slope of said voltage ramp generator and thereby affecting the critical edge of the output waveform of said voltage comparator.

9. The circuit of claim 4 wherein said phase-locked loop frequency synthesizer further comprises an offset mixer (98) having a first input electrically connected to the output (20) of said phase-locked loop, a second input (96) fed from a multiplier (94) interposed between said high stability, unmodulated reference signal source (32) and said offset mixer (98), and an output (100) whose frequency falls suitably within the range of operation desired.

10. A circuit for frequency modulating the output of a phase-locked loop frequency synthesizer providing an essentially flat modulating frequency response independent of the loop bandwidth, said circuit comprising in combination:

a phase-locked loop frequency synthesizer having a high stability, unmodulated reference oscillator (32) with a fixed-integer divider (34) as the reference signal source (12), a phase detector (16), a voltage controlled oscillator (18) having a loop filter (38), and a feedback path between said voltage controlled oscillator (18) and said phase detector (16) and including a selectable-integer divider (40);

a frequency modulator (36,42) interposed between said reference signal source (32,34) and said phase detector (16);   and

a direct frequency modulation port (26) included at said voltage controlled oscillator (18),

said frequency modulator (36,42) and said direct frequency modulation port (26) being adapted for simultaneous feed in synchronism with a balanced amplitude and polarity so as to effect cancellation of the modulation at the output of said phase detector (16) and thereby provide an essentially flat modulating frequency response independent of the bandwidth of said phase-locked loop frequency synthesizer.

0209754

11.      A circuit for frequency modulating the output of a phase-locked loop frequency synthesizer providing an essentially flat modulating frequency response independent of the loop bandwidth, said circuit comprising in combination:

a phase-locked loop frequency synthesizer having a high stability, unmodulated reference oscillator (32) with a fixed-integer divider (34), a phase detector (16), a voltage controlled oscillator (18), and a feedback path between said voltage controlled oscillator (18) and said phase detector (16) and including a selectable-integer divider (40);

a frequency modulator (12',14') interposed between said selectable-integer divider (40) and said phase detector (16) in said feedback path (114); and

a direct frequency modulation port included at said voltage controlled oscillator (18),

said frequency modulator (12',14') and said direct frequency modulation port being adapted for simultaneous feed in synchronism with a balanced amplitude and polarity so as to effect cancellation of the modulation before being input to said phase detector (16) and thereby provide an essentially flat modulating frequency response independent of the bandwidth of said phase-locked loop frequency synthesizer.

0209754

Fig. 1

Fig. 2

Fig. 3

Fig. 4

Fig. 5

COMPARATOR

TO PHASE DETECTOR

MODULATION INPUT

fR FROM DIVIDER

COMPARATOR

2/4

0209754

# Fig. 6

MODULATION INPUT ⌐22

90

REFERENCE OSCILLATOR ⌐32   92   ÷2880 ⌐34   PHASE MODULATOR ⌐36   PHASE DETECTOR ⌐16   LOOP FILTER ⌐38   VOLTAGE CONTROLLED OSCILLATOR ⌐18   20   OFFSET MIXER ⌐98

42   24   26

X 8 ⌐94

÷ N ⌐40

96

100

OUTPUT FREQUENCY

020 9754

3/4

Fig. 7

110